# EUROPEAN PATENT APPLICATION

(11) **EP 0 743 541 A1**
(43) Date of publication of application: **20.11.1996**
(21) Application number: 96907806.2
(22) Date of filing: 06.03.1996
(51) Int. Cl.: G02B 5/10

(54) **MULTIPLE LAYER PIEZOELECTRIC DEFORMABLE BIMORPHIC MIRROR**

(30) Priority: 12.02.1996 RU 96102312
(71) Applicant: YALESTOWN CORPORATION N.V., Curaçao, Netherlands Antilles (AN)
(72) Inventor: SAFRONOV, Andrei Gennadievich, Moskovskaya obl., 141070 (RU)
(74) Representative: BOVARD AG - Patentanwälte
(86) International application number: RU9600053
(87) International publication number: WO9618919

(57) **Abstract**

A multilayer piezoelectric deformable bimorph mirror is presented for use in astronomical telescopes, laser industrial systems, guidance and tracking systems, comprising a housing **1** made as a sleeve with a cover **2.** The reflectance surface **3** is formed on the outer side of the bottom of the sleeve. At least two piezoceramic plates **4** are coupled to the inner surface of the sleeve bottom not extending beyond the limits of the reflectance surface. The piezoceramic plates have solid electrodes **5** on their opposite surfaces, polarisation vectors **6** of adjacent piezoceramic plates are oppositely directed and their like electrodes are electrically connected between each other by means of wires **7**. The sleeve is designed in one piece with the bottom of a variable thickness and the central part of the bottom carrying the reflectance surface **3** has a greater thickness compared to the peripheral part. The cavity of the housing **1** may be filled with an elastic sealant **10**.

## Description

### FIELD OF THE INVENTION.

The present invention relates to a controllable optics and can be used for a static and a dynamic control of radiation wavefront in a variety of optical devices and systems including astronomical telescopes, industrial laser instruments and optical systems of tracking and guidance.

### BACKGROUND OF THE INVENTION.

An uncooled deformable bimorph mirror is known comprising two piezoelectric plates, one of which is made to be reflectance and has 13 sectionalised control electrodes (see, J.-P.Gaffard, P. Jagourel, P. Gigan. Adaptive Optics: Description of available components at Laserdot. - Proc. SPIE, 1994, vol. 2201, p. 688-702). Deformations of the reflectance surface in this bimorph mirror are achieved as a result of a bending moment arising in active bimorph structure at deformations of piezoceramics in a direction parallel to the optical surface due to the reverse lateral piezo-electric effect. The greatest amplitude of the controllable displacements of the optical surface in this mirror doesn't exceed 10 µm and is obtained at the applying the maximum voltage (400 V) simultaneously on all the control electrodes. Deficiencies of this bimorph mirror are as follows: small amplitude of controllable deformations of the reflectance surface, low sensitivity (no more than 25 µm/kV), high labour intensity of the process of optical surface forming, low quality and stability of the optical surface as well as low strength and reliability of the mirror.

A multilayer piezoelectric deformable bimorph mirror is known comprising a housing made as a sleeve with a cover and a reflectance surface made on the outer side of the bottom of the sleeve, and a piezoelectric element attached to the inside of the bottom of the sleeve not extending beyond the limits of the reflectance surface (see SU patent, 1808159, HO1S 3/02, 1993). The mirror has an additional piezoceramic plate placed between the reflectance and main piezoceramic plates and rigidly coupled to both of them. This additional plate is used independently on the main plate, that means that its control electrode does not connected electrically with other electrodes. The purpose of this additional piezoceramic plate is to stabilise the initial working shape of the reflectance surface of the mirror, to decrease its electromechanical hysteresis and, under certain conditions, to extend the range of controllable displacements of the reflectance surface. In this case, deformations of the reflectance surface are achieved due to the bending moments arising at deformations of each piezoceramic plate and their further superposition. Each piezoceramic plate is deformed in a direction parallel to the reflectance surface due to the reverse lateral piezoelectric effect. Deficiencies of the mirror are as follows: existence of the electric potential on the metallic housing of the mirror, small amplitude of the controllable deformations of the reflectance surface (11.2 µm maximum), low sensitivity (37.3 µm/kV maximum), high labour intensity of the optical surface forming process, low quality and stability of the optical surface as well as low strength and reliability of the mirror.

### SUMMARY OF THE INVENTION.

An object of the present invention is to provide the increase in amplitude of controllable optical surface displacements of the deformable bimorph mirror and to improve the mirror sensitivity. In addition to this, the proposed construction makes it possible to lower the labour input at the process of forming the optical surface of the mirror, to increase the quality and stability of its initial shape, to improve its strength and reliability, as well as to provide the more uniform deformation of the reflectance surface.

The said object is obtained by a multilayer piezoelectric bimorph mirror comprising a housing made as a sleeve having a cover and a reflectance surface formed on the outer side of the bottom of the sleeve, and a piezoelectric element coupled to the inner surface of the bottom of the sleeve not extending beyond the limits of the reflectance surface. The said piezoelectric element is made of at least two piezoceramic plates placed in series in parallel to the inner side of the bottom of the sleeve. The piezoceramic plates have electrodes made on their opposite surfaces. The electrodes are made solid. Polarisation vectors of adjacent piezoceramic plates are directed oppositely, their like electrodes are connected electrically between each other. The sleeve is made as a single piece having the bottom of a variable thickness. The reflectance surface is formed on the central part of the bottom which has a greater thickness. It is preferable to make the bottom of the sleeve to be cooled, and adjacent piezoceramic plates to be connected to each other by means of a common electrode and the cavity of the housing to be filled with an elastic sealing compound.

Increase in displacement amplitude of controllable optical surface of the bimorph mirror and enhancement of its sensitivity are obtained due to the following reasons:
1. Existence of additional bending moments arising from employment of each extra piezoceramic plate that is achieved by use of the piezoelectric element made of at least two piezoceramic plates;
2. Synchronous and in phase (that means equal in values and signs) deformations of all the piezoceramic plates that is obtained by use of the electrodes made solid and having polarisation vectors of adjacent plates oppositely directed and their like electrodes being electrically connected;
3. Decrease in rigidity of the reflectance surface (namely of the bottom of the sleeve) at its peripheral part and, therefore, providing a more elastic coupling to the reflectance surface. It is achieved by use of the sleeve made in one piece having the bottom of a variable thickness and the reflectance surface formed on the central part of the bottom having a greater thickness.

It should be noted that the first of the above listed reasons exists in the cooled bimorph mirror taken as a prototype. Indeed, when using a second piezoceramic plate in the mirror construction, an additional bending moment during its deformation arises which is added to the bending moment arising during deformation of the first piezoceramic plate. But in this case, the increase in overall bending moment arising in a two-layer bimorph structure, and, therefore increase in amplitude of reflectance surface deformations and the mirror sensitivity, may not occur because when going from a one-layer bimorph mirror to a multilayer structure a competition of the following three factors takes place:
1. Addition to the existing bending moment of the extra bending moment arising due to the presence of a new piezoceramic plate;
2. Decrease, in comparison with a one-layer mirror, in the value of bending moment caused by the deformations of the first piezoceramic plate, because, in case of a two-layer mirror, this bending moment must compensate a counter-action not only from the reflectance surface but also from the second (the new one) piezoceramic plate;
3. Addition to the existing bending moment of extra bending moment arising in the structure "the first (the old one) piezoceramic plate - the second (the new one) piezoceramic plate" due to the simultaneous deformations of both of the plates.

It is clear that with regard to the increase in the displacements amplitude of the controllable optical surface of the bimorph mirror and increase in its sensitivity, the first of above listed factors acts positively and the second acts negatively. Effect of the third factor is positive only if the extra bending moment arising in the structure "the first (the old one) piezoceramic plate - the second (the new one) piezoceramic plate" has the same sign as the moment arising due to deformations of the first (old) piezoceramic plates. But this is possible only if deformations of the second (new) piezoceramic plate has the same sign and exceeds in value the deformations of the first (old) piezoceramic plate. For all other cases effect of the third factor is negative even when deformations of both of piezoceramic plates are of the same sign but differ in value.

It is clear from the above-discussed that, when going from a one-layer mirror to a two-layer one, the first two factors are of a fundamental nature and always exist, and, therefore the second factor crucially can't be removed. Effect of the third factor may be turned into a positive if in every moment of time during the mirror operation a control voltage on the second piezoceramic plate is of the same sign and exceeds in value a control voltage on the first plate. Unfortunately, all the ways to exert a control of piezoceramic plates in a two-layer mirror in such a manner are strictly inconvenient. Indeed, first, all these ways require the availability of two independent control channels. Second, the value of control voltage on the second piezoceramic plate needs to be constantly compared with the value of voltage on the first piezoceramic plate that is very uncomfortable to do when the mirror operates in a dynamic mode.

When going from a two-layer mirror to a three-layer and further to a multilayer one, the effect of all three above-named factors becomes stronger, exactly:
1. The extra bending moment added to the existing bending moment is smaller with every extra piezoceramic plate added because the total rigidity of the bimorph structure increases more and more;
2. Values of bending moments caused by deformations of all existing piezoceramic plates, not only of the first one, decrease, because each piezoceramic plate in a multilayer mirror must compensate the counter-action of the reflectance surface and of all other piezoceramic plates;
3. Addition of extra bending moments arising in each bimorph structure formed by each pair of adjacent piezoceramic plates are added.

By analogy with a two-layer bimorph mirror it is clear that for a multilayer mirror it is impossible to obtain the above named object by simple increase of the number of piezoceramic plates. Apart of this, it is more difficult for a multilayer mirror than for a two-layer one to obtain a positive effect of the third factor, when the control voltage on all of the piezoceramic plates are of the same polarity and its value are more for each following plate than for a preceding one, and it is practically impossible in a dynamic mode. Therefore, almost always the effect of the third factor on the deformation amplitude is negative.

The present invention overcomes this situation by exclusion of the third factor at all due to a special design where all the couplings of each pair of adjacent plates are not bimorph. This is achieved when any two adjacent piezoceramic plates deform absolutely uniformly or, in other words, when, all other things being equal, a control voltage of the same value is applied to each piezoceramic plate. This is why the deformations of all the piezoceramic plates are synchronous and in phase, that is, as noted above (see item 2, p. 2) the second reason leading to the named object. The corresponding distinguishing feature of the invention is that all the electrodes are made solid, polarisation vectors of adjacent piezoceramic plates are oppositely directed and their like electrodes are electrically connected between each other. Hence, only a combination of this distinguishing feature with the first one (that the piezoelectric element is made of at least two piezoceramic plates and therefore is a multilayer one) provides the named technical object.

On the other hand, it should be noted, that even if the effect of the third factor is excluded, the competition between the first two factors still takes place It determines the existence of the optimum number of extra piezoceramic plates from the point of view of increase in sensitivity and controllable deformations of a multi-layer bimorph mirror. That is to say, that the addition of every extra piezoceramic plate (even providing the orientation and coupling as defined above) will lead not to the increase in amplitude of deformations but even to its decrease. In other words, the further increase in the number of piezoceramic plates will cause such an increase of the rigidity of a multi-layer bimorph structure that will not allow to obtain the named technical object.

The present invention overcomes this situation by the following: the increase in rigidity of the multi-layer bimorph structure is compensated with an excess by more elastic attachment to the housing of the mirror in comparison with the prototype. To do this, it appears to be enough to decrease the rigidity of the reflectance plate (or the bottom of the sleeve) at its peripheral part. That is, as noted above, the third reason which allows to obtain the named technical object. Here, the distinguishing feature is the fact that the sleeve is designed in one piece with the bottom of a variable thickness, and the reflectance surface formed on the central part of the bottom having a greater thickness. Therefore, only a combination of all the listed distinguishing features allows to obtain with a guarantee a reasonable increase in amplitude of optical surface controllable displacements of a multilayer bimorph mirror, that means to obtain with a guarantee a reasonable named above technical object.

In other words, a combination of the features characterising the embodiment of the housing and the piezoelectric element provides decrease of the total rigidity of the element carrying the reflectance surface and of the piezoelectric element that allows to increase significantly the mirror sensitivity. Though the utilisation of adjacent piezoceramic plates having polarisation vectors oppositely directed has been known, see US patent No. 4257686, Cl. G02F 1/00 issued March 24, 1981, only a combination of the above-named features with the features characterising the embodiment of the housing and arrangement of electrodes allows to obtain the above named technical object, that provides a correlated decrease in the weight of the element carrying the reflectance surface and of the piezoelectric element as well as the overall rigidity of all of the listed elements.

If the minimal possible thickness of piezoelectric plates is provided and the number of plates is increased proportionally, the increase in the mirror sensitivity is obtained, among other reasons, due to the reduction of the control voltage. This results directly form the fact that the sensitivity of the bimorph mirror is a ratio of value of optical surface deformation to the applied control voltage.

Decrease in a labour input into the process of the optical surface forming of the bimorph mirror and improvement of the quality of its initial shape are obtained by providing a sleeve made in one piece with a bottom of a variable thickness, the reflectance surface being formed on the central part of the bottom having a greater thickness. Immediate results arising from the above distinctive of the present invention are the following:
a) a more uniform contact between the optical surface of the mirror and the polishing tool during the polishing;
b) peripheral part of the housing, exactly the walls of the sleeve from the bottom side, is excluded out of the polishing process.

Another distinctive of the multilayer piezoceramic deformable bimorph mirror is that adjacent piezoceramic plates are connected to each other by means of a common electrode. It makes the construction more simple and convenient. In fact, in this case, only one electrode instead of two electrodes of two different piezoceramic plates is used located in the point of coupling of the plates.

Further distinctive of the present invention is that the cavity of the housing is filled with an elastic sealing compound. The elastic sealant dampens the pressure of the polishing tool on the reflectance surface during the polishing process, that makes the process of optical surface forming less labour intensive and provides the improvement of its initial shape quality. This provides a more uniform contact of optical surface with the polishing tool. Stability of the initial reflectance surface of the mirror as well as increase in its strength and reliability are obtained due to the damp by elastic sealing compound of outer impact, vibration and other loads acting onto the mirror housing during the mirror exploitation. The mirror reliability is increased also because the sealant protects the inner construction of the mirror against a direct damage. Apart of this, use of the sealing compound serves to return the sleeve bottom into its initial position. Therefore the present invention is consistent with the conditions of patentability , namely a novelty (N), an inventory skill(IS), an industrial adaptation (IA).

The above-listed advantageous of the present invention will be more clear from the following description of the embodiment and a drawing.

### BRIEF DESCRIPTION OF THE DRAWINGS.

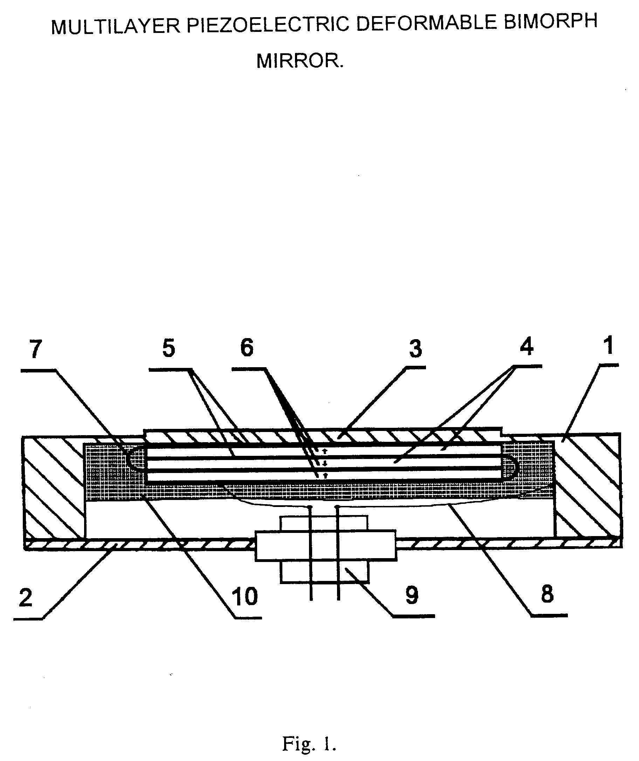

Fig. 1 is an overall view of a multilayer piezoceramic deformable bimorph mirror according to the present invention.

### DETAILED DESCRIPTION OF THE PREFERRED EMBODIMENT OF THE INVENTION.

Referring to the Fig. 1 the piezoceramic deformable bimorph mirror comprises a housing **1** designed in one piece, exactly a sleeve with a cover **2** and a reflectance surface formed on the outer surface of the bottom **1**. The central part of the bottom has a greater thickness compared to its peripheral part. A piezoceramic element is coupled to the inner surface of the sleeve bottom. The piezoceramic element comprises several (three, as shown in Fig. 1 or more) piezoceramic plates **4** arranged in parallel to the inner surface of the sleeve bottom. The piezoceramic plates have solid control electrodes **5** located on the opposite surfaces of the plates. Polarisation vectors **6** of adjacent plates **4**, as shown on Fig. 1, are oppositely directed. Their like electrodes **5** are connected between each other by means of conductors **7** and are connected by means of wires **8** to the electrical connector **9**. The housing cavity may be filled by a sealing compound **10**. As shown in Fig. 1 adjacent plates **4** are connected between each other by means of common electrodes **5**. The housing **1** bottom may be made cooled (not shown in Fig. 1).

The multilayer piezoelectric deformable bimorph mirror operates as follows. A control voltage is applied to each piezoceramic plate **4** through the electrical connector **9**. Therefore, all the piezoceramic plates **4** will deform due to the inverse lateral piezo-electric effect. The deformations will be equal for each of the plates **4** due to the specially selected orientation and electrodes **5** arrangement as described above. In other words, three-layer (and, therefore, a multilayer) piezoceramic structure will deform as one piece, that means, as a monolithic plate of a corresponding thickness. Therefore, providing a described above orientation of the piezoceramic plates **4** and connection of electrodes **5** , a multilayer piezoceramic structure will be equivalent to a monolithic piezoceramic plate.

With this in mind, it is easy to understand that the coupling "bottom of the housing 1 - multilayer piezoceramic structure" is equivalent to the coupling of two monolithic plates, one being a reflectance and another is a piezoceramic. Such a coupling is known (see, for example, Kokorowski S.A. Analysis of adaptive optical elements made from piezoelectric bimorph. - J. Opt. Soc. Am., 1979, v. 69, N 1, p. 181-187) as a seem-passive bimorph structure. Therefore, under the electrical voltage on the piezoceramics, the reflectance surface **3** of the mirror will deform in a certain manner, namely will deflect due to the bending moment arising in a bimorph structure. Therefore due to the combination of all named distinguishing features, as described above, the present embodiment provides with a guarantee a significant increase in amplitude of controllable displacements of the mirror optical surface.

As a sensitivity of the deformable mirror is a ratio of the value of reflectance surface deformations to the applied control voltage, it is seen from the above consideration, that in the proposed multilayer bimorph mirror the combination of all of the distinguishing features which characterise the design of the housing and of the piezoelectric element, also provides with a guarantee the increase in sensitivity compared to the known analogues and the prototype. It is obvious, that if the bimorph mirror construction uses more than three piezoceramic plates **4** or a multilayer piezoelement all above arguments are still valid, providing that the piezoceramic plates **4 are** oriented, electrodes **5** are connected and the housing **1 is** designed as described above.

The most simple and convenient embodiment of the present invention is obtained when adjacent piezoceramic plates are connected by means of a common electrode. Indeed, in this case a multilayer piezoelement can be made, for example, by caking of thin piezoelectric films over a platinum, instead of a simple coupling of individual piezoceramic plates having electrodes applied on the both surfaces of the electrode. In this case, the piezoceramic plates themselves have no control electrodes, and the platinum spacer serves for this purpose. In addition to this, a thermal treatment of piezoelectric films occurring during the caking turns them into rigid (but thin) piezoelectric plates. As a result, piezoelectric plates comprising the multilayer piezoelement appear to be coupled by the common electrode.

Earlier advantages arising due to the use of elastic sealing compound filling the cavity of the housing have already been noted. It remains to add, that when filling the housing cavity by a liquid sealing compound and its further drying out, ,here the adhesion occurs to the housing walls as well as to the surface of the piezoelement. So, the sealing compound acts as a kind of spring that returns the reflectance surface (exactly, the sleeve bottom) into its initial position under any loads acting in the process of the mirror manufacturing or exploitation.

It is required to stress, that the reflectance surface (the sleeve bottom) may be made cooled as it is in the prototype. For example, it may comprise channels allowing water or other coolant to pass through, arranged immediately under the reflectance surface **3**.

Another important advantage of the proposed embodiment of the multilayer bimorph mirror is the possibility to reduce the thickness of individual piezoelectric plates **4** in order to reduce values of control voltage without decrease in amplitudes of the reflectance surface useful deformations, and, therefore, to increase the sensitivity still further. For the known analogues and the prototype there is a lower limit of the thickness of a single piezoceramic plate because its rigidity must be large enough to provide a maximum deflection (sag) of the reflectance surface. From the other hand, the overall thickness of the bimorph structure has a lower limit too, because its rigidity must provide the ability to form the optical surface and polish the mirror. Therefore, for the known analogues and the prototype there is a maximum allowable thickness that enables to obtain a deformable bimorph mirror with an effective performance.

From the described above it is clear that for a proposed multilayer bimorph mirror there is no any limits in thickness for individual piezoceramic plates **4**. It is obvious that the possible deficiency in rigidity of the whole piezostructure can be easily compensated by the increase in the number of piezoelectric plates **4**. Therefore, the proposed embodiment provides the possibility to produce low-voltage high-sensitivity one-channel deformable bimorph mirrors with large amplitude of controllable displacements of the optical surface.

### INDUSTRIAL APPLICATIONS.

The present invention can be realised at a standard industrial equipment using known materials and technological procedures. Piezoelectric plates used in the mirror construction are also a standard industrial product.

Practically, the present invention can be used in any optical systems where there is a need in a high-accuracy dynamic correction (compensation) of axial-symmetric distortions of optical beams, for example in the industrial laser systems with a "flying" optics in order to obtain a uniform weld over the whole field under processing.

## Claims

1. A multilayer piezoelectric deformable bimorph mirror comprising a housing designed as a sleeve with a cover and a reflectance surface made on the outer side of the sleeve bottom, and a piezoelectric element coupled to the inner surface of the sleeve bottom not extending beyond the limits of the reflectance surface, in which mirror the piezoelectric element is made of at least two piezoceramic plates located in series in parallel to the inner surface of the sleeve bottom. The piezoceramic plates have electrodes on their opposite surfaces, the electrodes are solid, polarisation vectors of adjacent piezoceramic plates are oppositely directed and their like electrodes are electrically connected between each other. The sleeve is designed in one piece with the bottom of a variable thickness and the reflectance surface is formed on the central part of the bottom having a greater thickness.

2. A mirror as clamed in Claim 1 in which the sleeve bottom is made cooled.

3. A mirror as claimed in Claim 1 and Claim 2 in which adjacent piezoceramic plates are connected with each other by means of a common electrode.

4. A mirror as claimed in any of Claims 1 - 3 in which a cavity of the housing is filled by elastic sealing compound.
